# EUROPEAN PATENT APPLICATION

(11) **EP 4 848 930 A2**
(43) Date of publication of application: **02.12.2026**
(21) Application number: 26212193.2
(22) Date of filing: 10.06.2024
(51) Int. Cl.: H10D 8/80

(54) **ELECTROSTATIC DISCHARGE (ESD) PROTECTION CIRCUIT INCLUDING AN AVALANCHE SEMICONDUCTOR CONTROLLED RECTIFIER (SCR) WITH PARALLEL CONNECTED STATIC TRIGGER CONTROL CIRCUIT (TCC)**

(30) Priority: 29.06.2023 US 202318215899
(62) Document number(s) of the earlier application(s) in accordance with Art. 76 EPC: 24181046.4 / 4 485 533
(71) Applicant: STMicroelectronics International N.V., 1228 Plan-les-Ouates, Geneva (CH)
(72) Inventor: DI BICCARI, Leonardo, 20864 Agrate Brianza (MB) (IT)
(74) Representative: Studio Torta S.p.A.

(57) **Abstract**

A two terminal semiconductor controlled rectifier (SCR) device has an anode terminal coupled to a first node and a cathode terminal coupled to a second node. Neither of the cathode gate or anode gate of the SCR device are connected to a triggering circuit for controlling turn on of the SCR device. The SCR device has an avalanche breakdown voltage for turn on, where that avalanche breakdown voltage is set by a breakdown avalanche of a PN junction of the SCR device. A circuit path includes a series connected chain of M Zener diodes with a blocking diode that are coupled between the first node and the second node. The circuit path has an activation voltage for turn on, where that activation voltage is dependent on N times a Zener diode reverse breakdown voltage. The activation voltage is less than the avalanche breakdown voltage.

## Description

### TECHNICAL FIELD

The present disclosure generally relates to electrostatic discharge (ESD) protection circuitry for integrated circuit devices.

### BACKGROUND

Electrostatic discharge (ESD) protection for the input/output (I/O) and other pins (or pads) of integrated circuits is needed in many applications. This is of special concern for the high voltage (HV) input/output pins used for low capacitive/high speed communications signals (such as for use on data communications bus lines).

Mandatory requirements for HV ESD protection of certain input/output pins of integrated circuit (IC) devices (such as for low capacitive/high speed HV input/output with System-level specifications like IEC 62228-3 and/or SAE J2962) include: low capacitance; limited area occupancy; high current/power capability; and high immunity to different electromagnetic (EM) events such as with different stress rise times and current duration source type (for example, direct power injection testing or transient immunity testing). The HV ESD protection must also exhibit a high immunity and robustness in both the supplied IC case and the unsupplied IC case. Furthermore, high immunity to unwanted triggering is necessary (as in the case, for example, of inductive effects on the input/output pin).

Implementation of integrated HV ESD protection with a low area occupancy (low capacitance) and high robustness (current capability) along with high EM immunity is a challenge. Embodiments described herein address the need for an improved integrated HV ESD protection.

### SUMMARY

The present invention relates to an electrostatic discharge (ESD) protection circuit, as defined in claim 1.

The present disclosure is summarized hereunder.

In one example, an electrostatic discharge (ESD) protection circuit comprises: a first semiconductor controlled rectifier (SCR) device of two terminal type consisting of an anode terminal and a cathode terminal, and wherein said first SCR device has an avalanche breakdown voltage for self-turn on, that is an avalanche breakdown voltage threshold at which the first SCR device turns-on, specifically without the need for a triggering circuit for controlling turn on of the first SCR device; a first circuit path having a first node and a second node, and wherein said first circuit path has an activation voltage for turn on; wherein the first SCR device and first circuit path are connected in parallel with the anode terminal and the first node coupled to a first pin and with the cathode terminal and the second node coupled to a second pin; and wherein said activation voltage is less than the avalanche breakdown voltage.

In another example, a semiconductor controlled rectifier (SCR) device having an anode terminal directly connected to a first pin of an integrated circuit, a cathode terminal directly connected to a second pin of the integrated circuit, and wherein both a cathode gate node and an anode gate node of the SCR device are not connected to a triggering circuit for controlling turn on of the SCR device; and a circuit path having a first end node directly connected to the first pin of the integrated circuit and a second end directly connected to the second pin of the integrated circuit, wherein said circuit path comprises a series connected chain of M Zener diodes; wherein the SCR device has an avalanche breakdown voltage for turn on, said avalanche breakdown voltage set by a breakdown avalanche of a PN junction of the SCR device; wherein the circuit path has an activation voltage for turn on, said activation voltage being dependent on M times a Zener diode reverse breakdown voltage; and wherein said activation voltage is less than the avalanche breakdown voltage.

### BRIEF DESCRIPTION OF THE DRAWINGS

For a better understanding of the embodiments, reference will now be made by way of example only to the accompanying figures in which:
Figure 1 is a circuit diagram for an electrostatic discharge (ESD) protection circuit using a triggered semiconductor controlled rectifier (SCR) device;
Figure 2 is a circuit diagram for an ESD protection circuit using an avalanche SCR device and parallel connected static trigger control circuit (TCC);
Figure 3 is current versus voltage plot;
Figure 4A is a circuit diagram for an ESD protection circuit using an avalanche SCR device and parallel connected static trigger control circuit (TCC);
Figure 4B shows an example layout configuration for the ESD protection circuit of Figure 4A; and
Figures 5, 6 and 7 show circuit diagrams for alternative embodiments of the ESD protection circuit.

### DETAILED DESCRIPTION

Like features have been designated by like references in the various figures. In particular, the structural and/or functional features that are common among the various embodiments may have the same references and may dispose identical structural, dimensional and material properties.

Unless indicated otherwise, when reference is made to two elements connected together, this signifies a direct connection without any intermediate elements other than conductors, and when reference is made to two elements coupled together, this signifies that these two elements can be connected or they can be coupled via one or more other elements.

In the following description, when reference is made to terms qualifying absolute positions, such as terms "front", "rear", "top", "bottom", "left", "right", etc., or relative positions, such as terms "above", "under", "upper", "lower", etc., or to terms qualifying directions, such as terms "horizontal", "vertical", etc., unless specified otherwise, it is referred to the orientation of the drawings.

A semiconductor (silicon) controlled rectifier (SCR) device is a well-known, and widely used, circuit for on-chip electrostatic discharge (ESD) protection. The SCR device is typically connected between a signal (input or output) pin of the integrated circuit and a ground (reference voltage) pin of the integrated circuit.

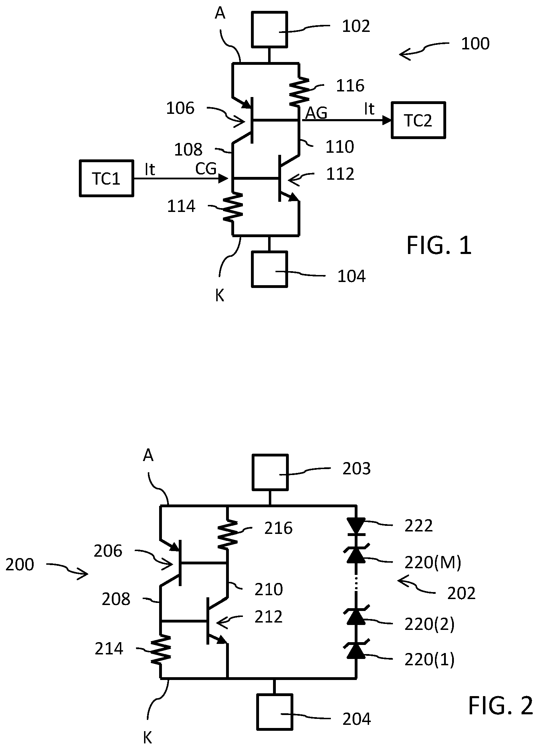

Figure 1 shows a circuit diagram for an ESD protection circuit using a gate triggered SCR device 100. The SCR device 100 is a three (or more) terminal device that includes an anode node A terminal, a cathode node K terminal, and one or more of an anode gate AG terminal and/or a cathode gate CG terminal. In an ESD protection scheme according to an embodiment, the anode node A is coupled, preferably directly connected, to the signal (input/output) pin 102 and the cathode node K is coupled, preferably directly connected, to the reference or ground pin 104. A PNP-type bipolar transistor 106 has an emitter coupled, preferably directly connected, to the anode node A, a collector coupled, preferably directly connected, to a first internal base node 108 at the cathode gate CG, and a base coupled, preferably directly connected, to a second internal base node 110 at the anode gate AG. An NPN-type bipolar transistor 112 has a collector coupled, preferably directly connected, to the second internal base node 110 at the anode gate AG, an emitter coupled, preferably directly connected, to the cathode node K, and a base coupled, preferably directly connected, to the first internal base node 108 at the cathode gate CG. A first resistor 114 (provided by a resistance of a doped well in a silicon substrate) has a first terminal coupled, preferably directly connected, to the first internal base node 108 at the cathode gate CG and a second terminal coupled, preferably directly connected, to the cathode node K. A second resistor 116 (provided by a resistance of a doped well in a silicon substrate) has a first terminal coupled, preferably directly connected, to the second internal base node 110 at the anode gate AG and a second terminal coupled, preferably directly connected, to the anode node A.

When the SCR device 100 is in the off-state, the flow of current between the anode node A and the cathode node K is blocked. Turning on the SCR device 100 (i.e., switching from the off-state to the on-state) is typically controlled by the application of a gate signal to either the cathode gate CG at the first internal base node 108 or the anode gate AG at the second internal base node 110 in the presence of a sufficient voltage potential difference between the anode node A and the cathode node K. In the on-state, current flows between the anode node A and the cathode node K until the voltage at the anode node A (referenced to the ground voltage at the cathode node K) falls below a holding voltage level.

For example, turning on the SCR device 100 can be effectuated through the use of a triggering current It that is sourced to the cathode cate CG at the first internal base node 108 by a triggering circuit TC1 (this is referred to in the art as cathode gate controlling the SCR 100). This turns on the NPN-type bipolar transistor 112 and current flows through the collector-emitter path of NPN-type bipolar transistor 112. This current flow sinks current from the base of the PNP-type bipolar transistor 106 and causes the PNP-type bipolar transistor 106 to turn on. The flow of current from the anode node A through the collector-emitter path of PNP-type bipolar transistor 106 is sourced to the base of the NPN-type bipolar transistor 112 and is used to sustain the turn on of the NPN-type bipolar transistor 112. The sourcing of the triggering current It to the cathode gate CG at the first internal base node 108 is then no longer needed for SCR device 100 turn on. The SCR device 100 will remain in the on-state provided sufficient current remains available through the PNP-type bipolar transistor 106 from the anode node A due to the voltage potential difference present between the anode node A and the cathode node K.

Conversely, a triggering current It can be sunk from the anode gate AG at the second internal base node 110 by a triggering circuit TC2 (this is referred to in the art as anode gate controlling the SCR 100). This turns on the PNP-type bipolar transistor 106 and current flows through the collector-emitter path of PNP-type bipolar transistor 106. This current flow sources current to the base of the NPN-type bipolar transistor 112 and causes the NPN-type bipolar transistor 112 to turn on. The flow of current to the cathode node K through the collector-emitter path of NPN-type bipolar transistor 112 is sunk from the base of the PNP-type bipolar transistor 106 and is used to sustain the turn on of the PNP-type bipolar transistor 106. The sinking of the triggering current It from anode gate AG at the second internal base node 110 is then no longer needed for turn on. The SCR device 100 will remain in the on-state provided sufficient current remains available through the PNP-type bipolar transistor 106 from the anode node A due to the voltage potential difference present between the anode node A and the cathode node K.

The triggering circuit TC1, TC2 is used to sense an ESD event at the pin 102, 104 and generate the required pulse of current It for the triggering signal to control turn on the SCR device 100 in response to that sensed ESD event. The current flowing through the SCR device 100 when turned on will dissipate the ESD stress.

Figure 2 is a circuit diagram for an ESD protection circuit using an avalanche SCR device 200 and parallel connected static trigger control circuit (TCC) 202.

The SCR device 200 here is a two terminal device, wherein one terminal is an anode node A terminal and the other terminal is a cathode node K terminal. In particular, the SCR device 200 consists of two terminals, wherein one is the anode node A terminal and the other is the cathode node K terminal. A PNP-type bipolar transistor 206 has an emitter coupled, preferably directly connected, to the anode node A, a collector coupled, preferably directly connected, to a first internal base node 208, and a base coupled, preferably directly connected, to a second internal base node 210. An NPN-type bipolar transistor 212 has a collector coupled, preferably directly connected, to the second internal base node 210, an emitter coupled, preferably directly connected, to the cathode node K, and a base coupled, preferably directly connected, to the first internal base node 208. A first resistor 214 (provided by a resistance of a doped well in a silicon substrate) has a first terminal coupled, preferably directly connected, to the first internal base node 208 and a second terminal coupled, preferably directly connected, to the cathode node K. A second resistor 216 (provided by a resistance of a doped well in a silicon substrate) has a first terminal coupled, preferably directly connected, to the second internal base node 210 and a second terminal coupled, preferably directly connected, to the anode node A. In view of the two terminal configuration of the SCR device 200, neither the first internal base node 208 nor the second internal base node 210 are in any way externally (from the perspective of the SCR) connected or connectable or coupled or couplable through circuitry (such as trigger circuitry) to the anode terminal or cathode terminal.

The TCC 202, also referred to herein as a circuit path, includes a series connected chain of M Zener diodes 220(1) to 220(M) that are coupled between the anode node A and the cathode node K. The series connection of the Zener diodes 220(1) to 220(M) is in a head-to-tail type connection where the cathode of one Zener diode is directly connected to the anode of the next Zener diode. The anode of the first Zener diode 220(1) in the chain is coupled, preferably directly connected, to the cathode node K. The cathode of the last Zener diode 220(M) is coupled to the anode node A through a blocking diode 222. The cathode of the blocking diode 222 is coupled, preferably directly connected, to the cathode of the last Zener diode 220(M) and the anode of the blocking diode 222 is coupled, preferably directly connected, to the anode node A.

The blocking diode 222 is included to avoid current conduction through the TCC 202 from cathode node K to anode node A during a negative ESD event. The presence of the blocking diode 222 further protects against possible activation of a parasitic conduction path embedded in the integrated circuit structure for the TCC 202. Another advantage of including the diode 222 is that it avoids any issue or constraint in terms of the integrated circuit layout for the TCC 202 due to excessive current/power dissipation at the silicon or metal level.

In an alternative embodiment, the blocking diode 222 is not present in the TCC 202 and the cathode of the last Zener diode 220(M) is directly connected to the anode node A.

In an ESD protection scheme according to an embodiment, the anode node A is coupled, preferably directly connected, to the signal pin 203 (for example, an input/output pin of the integrated circuit) and the cathode node K is coupled, preferably directly connected, to the reference (ground) pin 204 of the integrated circuit.

It is important to note that the SCR device 200, because it consists of a two terminal device (anode terminal and cathode terminal only), does not include a gate terminal for controlling turn on and thus does not utilize an anode or cathode gate triggering circuit to source/sink a triggering current pulse to either of the first and second internal base nodes 208, 210. Indeed, no circuit connection to a cathode gate or anode gate is made as the SCR device 200 operates independently (i.e., self-turn on and off of the SCR occurs without application of any gate control signaling, that is in the absence of a gate control signal for turn-on). To accomplish self-turn on of the SCR device 200 in the ESD protection circuit of Figure 2 in the absence of an anode gating or cathode gating control signal, a voltage is needed that exceeds the breakdown avalanche of the reverse biased PN junction between the n-type doped region for the collector of the NPN-type bipolar transistor 212 and the p-type doped region for the base of the NPN-type bipolar transistor 212. This voltage is referred to herein as the avalanche breakdown voltage V_{SCR} for the SCR device 200. When this PN junction avalanches, current is sunk from the base of the PNP-type bipolar transistor 206. This turns on the PNP-type bipolar transistor 206 and current flows through the collector-emitter path of PNP-type bipolar transistor 206 to the base of the NPN-type bipolar transistor 212. This base current will control turn on the NPN-type bipolar transistor 212. The flow of current through the collector-emitter path of the turned on NPN-type bipolar transistor 212 then sustains the turn on of the PNP-type bipolar transistor 206. The SCR device 200 will remain in the on-state provided sufficient current remains available through the PNP-type bipolar transistor 206 from the anode node A due to the voltage potential difference present between the anode node A and the cathode node K.

In a preferred implementation of the ESD protection circuit of Figure 2, the avalanche breakdown voltage V_{SCR} for the SCR device 200 is set to be greater than the activation voltage V_{TCC} of the TCC 202. This is a critical feature for the design of the ESD protection circuit in order to ensure that the TCC 202 turns on (and begins current dissipation) before the SCR device 200 in response to an ESD event.

The setting of the avalanche breakdown voltage V_{SCR} for the SCR device 200 is accomplished by controlling the PNP and NPN junctions of transistors 206 and 212 as well as the value of the parasitic resistance of a doped well in a silicon substrates of resistors 214, 216. This is accomplished, for example, by controlling the size, spacing and doping levels of the doped wells and doped regions in the semiconductor (silicon) layer of the integrated circuit device which form the PNPN structure of the SCR 200. For example, the architecture of the SCR device 200 is defined with a specific cross section (i.e., number and location of active regions, usage of field plate approach for controlling electric field and potential distribution on silicon). Then, the size, spacing and doping levels of the doped wells and doped regions will set a precise avalanche breakdown voltage for the SCR device 200.

The activation voltage V_{TCC} of the TCC 202 is equal to the sum of the reverse breakdown voltages for the series connected chain of M Zener diodes 220(1) to 220(M) plus the forward voltage drop of the blocking diode 222. The setting of the reverse breakdown voltage for each Zener diode 220 is accomplished by controlling the size, spacing and doping levels of the doped wells, implants and doped regions in the semiconductor substrate of the integrated circuit device which form each diode 220. The forward voltage drop of the blocking diode 222, for example, implemented as a common PN junction, is typically in the range of 0.5 to 0.7 Volts.

The voltage intervention of the TCC 202 for ESD protection, in other words the activation voltage V_{TCC}, is defined according to the voltage protection requirements for the signal pin 203 (for example, an input/output pin of the integrated circuit). For example, if voltage protection requirements for the signal pin 203 are for an absolute maximum rating (AMR) of +40 Volts, the TCC 202 is designed with an activation voltage V_{TCC} of about +45 Volts (i.e., in excess of the AMR). So, there will be no current conduction for ESD protection up to at least the AMR of the pin 203, and the activation voltage V_{TCC} will be set higher than the AMR rating with a suitable margin. For a Zener diode 220 with a reverse breakdown voltage of +5 Volts, the TCC 202 would include a series connected chain of M=9 Zener diodes 220(1) to 220(9) to provide an activation voltage V_{TCC} that is approximately equal to +45 Volts. The SCR device 200 in this example would be designed with an avalanche breakdown voltage V_{SCR} (i.e., the avalanche breakdown of the reverse biased PN junction) for self-turn on of the SCR that is greater than the activation voltage V_{TCC}, such as a breakdown voltage that is approximately equal to +51 Volts. The SCR device 200 may further exhibit, in such a case, a threshold voltage for snap-back that is approximately equal to +55 Volts.

It will be noted that there is no operational link between the SCR device 200 and the TCC 202. For example, as noted in connection with the embodiment of Figure 1, the SCR 200 typically includes an anode or cathode gate triggering circuit. The TCC 202 in Figure 2 does not function as a trigger for the SCR device 200. The avalanche breakdown voltage V_{SCR} for the SCR device 200, as well as the threshold voltage for snap-back, is defined univocally by the design of the SCR device 200 itself. The SCR device 200 and the TCC 202 are thus independently operated within the ESD protection circuit of Figure 2.

It will also be noted that the TCC 202 is not a MOS-based semiconductor device. The current in the TCC 202 does not flow through a MOS channel region. Because of this, the TCC 202 is not sensitive to dV/dt concerns or any external fast transient or ringing (with respect to the anode node A or cathode node K) which can be a significant concern when using MOS-based circuits. Operation of the TCC 202 is based solely on the use of PN junctions (with Zener diodes being one example of such a PN junction). As a result, the TCC 202 exhibits a more robust performance against EM or ESD events.

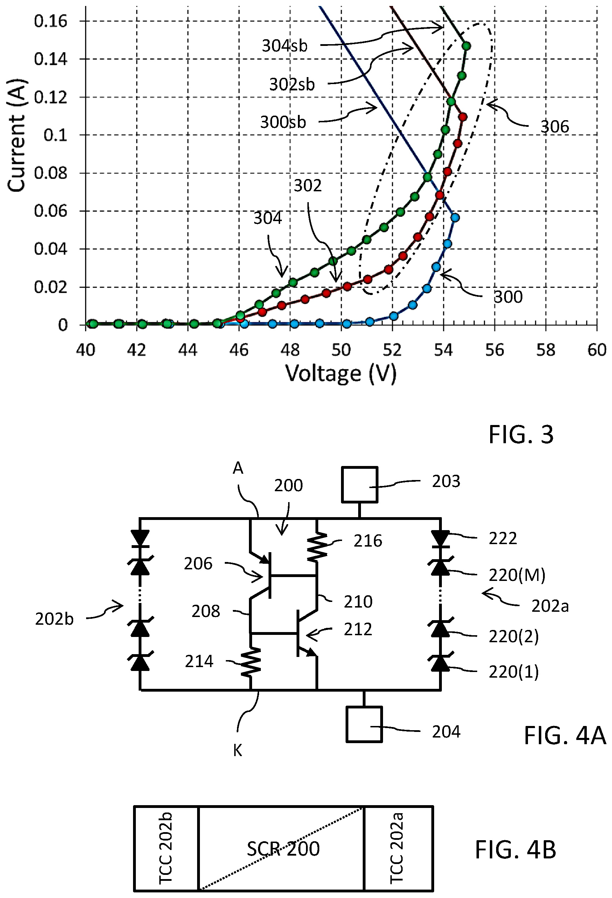

Reference is now made to Figure 3 which shows a current versus voltage plot.

Line 300 illustrates the current versus voltage operating characteristic of an ESD protection circuit which uses the avalanche SCR device 200 alone. The SCR circuit 200 is designed with an avalanche breakdown voltage V_{SCR} for self-turn on that is approximately equal to +51 Volts (with a threshold voltage for snap-back of approximately +55 Volts). When the voltage at the signal pin 203 rises to a level where the voltage at the collector of transistor 210 exceeds the avalanche breakdown voltage V_{SCR} of the reverse biased PN junction (about +51 Volts), current through the SCR 200 from signal pin 203 to reference (ground) pin 204 begins to flow. There is an increase in current through the SCR 200 with corresponding increase in voltage at the signal pin 203 until the threshold voltage at about +55 Volts is reached. At this point, the SCR device 200 transitions to operation in snap-back (line 300sb).

Line 302 illustrates the current (I) versus voltage (V) operating characteristic of a first embodiment of the ESD protection circuit of Figure 2 which uses an avalanche SCR device 200 and parallel connected static trigger control circuit (TCC) 202. In this embodiment, the TCC 202 uses a series connected chain of M=9 Zener diodes 220(1) to 220(9), where each Zener diode 220 has a reverse breakdown voltage of +5 Volts and a first size (for example, given by the parameter N=20, where N indicates a number of diode structures electrically connected in parallel for each diode 220). When the voltage at the signal pin 203 rises to a level that exceeds the activation voltage V_{TCC} of the TCC 202 of approximately +45 Volts, current through the TCC 202 from signal pin 203 to the reference (ground) pin 204 begins to flow. The amount of current that flows here is related to the size (N=20) of the Zener diode 220 devices. There is an increase in current through the TCC 202 with corresponding increase in voltage at the signal pin 203 until the voltage at the collector of transistor 210 exceeds the avalanche breakdown voltage V_{SCR} of the reverse biased PN junction (about +51 Volts) for self-turn on of the SCR. At this point an increased level of current flows from signal pin 203 to reference (ground) pin 204 using two current paths - one path through the TCC 202 and another path through the SCR device 200. Thus, the ESD protection circuit of Figure 2 supports shared current flow with TCC 202 and SCR device 200 in the V-I operating region indicated at reference 306. There is an increase in current flow with corresponding increase in voltage at the signal pin 203 until the threshold voltage level at about +55 Volts is reached. At this point, the SCR device 200 transitions to operation in snap-back (line 302sb). After the point where the SCR device 200 transitions to operation in snap-back and the voltage falls below the activation voltage V_{TCC} of the TCC 202, current flow through the TCC 202 terminates and the ESD event discharge is handled solely by the SCR device 200.

Line 304 illustrates the current versus voltage operating characteristic of a second embodiment of the ESD protection circuit of Figure 2 which uses an avalanche SCR device 200 and parallel connected static trigger control circuit (TCC) 202. In this embodiment, the TCC 202 uses a series connected chain of M=9 Zener diodes 220(1) to 220(9), where each Zener diode 220 has a reverse breakdown voltage of +5 Volts and a second size (for example, given by the parameter N=40, where N indicates the number of diode structures connected in parallel for each Zener diode 220). Thus, the Zener diodes 220 in this embodiment are twice as large as the Zener diodes 220 in the previous embodiment. When the voltage at the signal pin 203 rises to a level that exceeds the activation voltage V_{TCC} of the TCC 202 of approximately +45 Volts, current through the TCC 202 from signal pin 203 to reference (ground) pin 204 begins to flow. The amount of current that flows here is related to the size (N=40) of the Zener diode 220 devices. Note here that because the Zener diodes 220 are larger, there is larger current flow through the TCC 202 in this embodiment compared to the previous embodiment. There is an increase in current through the TCC 202 with corresponding increase in voltage at the signal pin 203 until the voltage at the collector of transistor 210 exceeds the avalanche breakdown voltage V_{SCR} of the reverse biased PN junction (about +51 Volts) for self-turn on of the SCR. At this point an increased level of current flows from signal pin 203 to reference (ground) pin 204 using two current paths - one path through the TCC 202 and another path through the SCR device 200. Thus, the ESD protection circuit of Figure 2 supports shared current flow with TCC 202 and SCR device 200 in the region indicated at reference 306 which follows the current contribution shown by line 300. There is an increase in current flow with corresponding increase in voltage at the signal pin 203 until the threshold voltage level at about +55 Volts is reached. At this point, the SCR device 200 transitions to operation in snap-back (line 304sb). After the point where the SCR device 200 transitions to operation in snap-back and the voltage falls below the activation voltage V_{TCC} of the TCC 202, current flow through the TCC 202 terminates and the ESD event discharge is handled solely by the SCR device 200.

Although a preferred embodiment of the TCC 202 uses Zener diodes 220, it is also possible to instead implement the TCC 202 with another type of avalanche-triggered semiconductor device connected in a series chain. For example, the series connection of Zener diodes 220 could be replaced with a series connection of reverse biased PN diodes (non-limiting examples of which include: high voltage PN diodes; one or more bipolar NPN and PNP transistors in series with shorted base/emitter or base/collector terminals; one or more reverse biased gate-grounded MOS (GGMOS) transistors (i.e., completely turned off with no MOS conduction channel)).

Although a preferred embodiment of the TCC 202 uses a blocking diode 222, it is also possible to instead implement the TCC 202 with another type of current blocking semiconductor device. For example, the blocking diode 222 could be implemented with a PN diode (non-limiting examples of which include: a high voltage PN diode; an NPN or PNP transistor shorted base/emitter or base/collector terminals; a gate-grounded MOS (GGMOS) transistors).

A noted advantage of the ESD protection circuit of Figure 2 compared to the ESD protection circuit of Figure 1 is a reduction in occupied integrated circuit area. The SCR device 200 has a size that generally scales with desired current carrying capacity and level of immunity (current value for snap-back). As the protection requirements for the signal pin 203 increase, so does the size of the SCR device 200. Based on immunity requirements, an overdesign of the SCR device in terms of current carrying capacity is possible. For the ESD protection circuit of Figure 2, however, there are two current conduction paths and the presence of the current conduction path for the TCC 202 eases the design requirements for the SCR device 200 to support operation in the region indicated at reference 306 of Figure 3. As a result, for a same current carrying capacity requirement, there may be a 15-25% reduction in occupied integrated circuit area by using the ESD protection circuit of Figure 2.

Reference is now made to Figure 4A. The ESD protection circuit of Figure 4A differs from the ESD protection circuit of Figure 2 only in that a first TCC 202a and a second TCC 202b are connected in parallel with each other and the two terminal SCR device 200 between the signal pin 203 and reference (ground) pin 204. Each of the first TCC 202a and second TCC 202b includes a first series connected chain of M Zener diodes 220(1) to 220(M) that are coupled between the anode node A terminal and the cathode node K terminal. The series connection of the Zener diodes 220(1) to 220(M) is in a head-to-tail type connection where the cathode of one Zener diode is directly connected to the anode of the next Zener diode. In each of the first and second TCC 202a and 202b: the anode of the first Zener diode 220(1) in the chain is coupled, preferably directly connected, to the cathode node K; and the cathode of the last Zener diode 220(M) is coupled to the anode node A through a blocking diode 222 (where the cathode of the blocking diode 222 is coupled, preferably directly connected, to the cathode of the last Zener diode 220(M), and the anode of the blocking diode 222 is coupled, preferably directly connected, to the anode node A).

The use of the first TCC 202a and second TCC 202b in this configuration is to obtain a more effective connection for the circuit at layout level between the SCR device 200 and the TCC 202. For example, consider that a more uniform trigger mechanism provided by the SCR device 200 and TCC 202 can be obtained by splitting the TCC 202 into two branches (one with TCC 202a and another with TCC 202b), and connecting those branches in a symmetric way with respect to the layout of the SCR device 200 (for example, relative to the dotted diagonal line across the layout area of the SCR device as shown in Figure 4B).

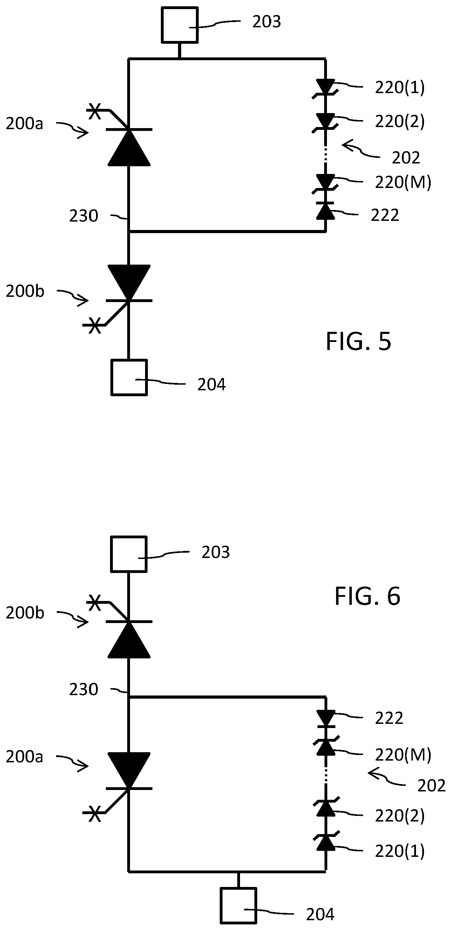

Reference is now made to Figure 5 which shows a circuit diagram for another embodiment of an ESD protection circuit. Here, the included two terminal SCR devices 200 are shown by use of their conventional schematic symbols. The SCR device 200a has a cathode node K terminal coupled, preferably directly connected, to signal pin 203, an anode node A terminal coupled, preferably directly connected, to intermediate node 230, and a disconnected cathode gate CG (indicated by the "X" for no transistor base access or trigger circuit connection). The SCR device 200b has a cathode node K terminal coupled, preferably directly connected, to reference (ground) pin 204, an anode node A terminal coupled, preferably directly connected, to intermediate node 230, and a disconnected cathode gate CG (indicated by the "X" for no transistor base access or trigger circuit connection). Importantly, in view of the two terminal configuration, neither of the SCR devices 200a, 200b are gate controlled (anode or cathode) by a trigger circuit for turn on in any way (i.e., these SCR devices support self-turn on dependent on applied voltage as discussed above). The TCC 202 is connected between the signal pin 203 and the intermediate node 230. The TCC 202 includes a series connected chain of M Zener diodes 220(1) to 220(M) that are coupled between the signal pin 203 and the intermediate node 230. The series connection of the Zener diodes 220(1) to 220(M) is in a head-to-tail type connection where the cathode of one Zener diode is directly connected to the anode of the next Zener diode. The anode of the first Zener diode 220(1) in the chain is coupled, preferably directly connected, to the pin 203 at the cathode node K of SCR device 200a. The cathode of the last Zener diode 220(N) is coupled to the intermediate node 230 through a blocking diode 222. The cathode of the blocking diode 222 is coupled, preferably directly connected, to the cathode of the last Zener diode 220(N) and the anode of the blocking diode 222 is coupled, preferably directly connected, to the intermediate node 230 at the anode node A of SCR device 200a. The activation voltage V_{TCC} of the TCC 202 is set to be less than the avalanche breakdown voltage V_{SCR} of the SCR device 200a.

Reference is now made to Figure 6 which shows a circuit diagram for another embodiment of an ESD protection circuit. Here, the included two terminal SCR devices 200 are shown by use of their conventional schematic symbols. The SCR device 200a has a cathode node K terminal coupled, preferably directly connected, to reference (ground) pin 204, an anode node A terminal coupled, preferably directly connected, to intermediate node 230, and a disconnected cathode gate CG (indicated by the "X" for no transistor base access or trigger circuit connection). The SCR device 200b has a cathode node K terminal coupled, preferably directly connected, to signal pin 203, an anode node A terminal coupled, preferably directly connected, to intermediate node 230, and a disconnected cathode gate CG (indicated by the "X" for no transistor base access or trigger circuit connection). Importantly, in view of the two terminal configuration, neither of the SCR devices 200a, 200b are gate controlled (anode or cathode) by a trigger circuit for turn on in any way (i.e., these SCR devices support self-turn on dependent on applied voltage as discussed above). The TCC 202 is connected between the reference (ground) pin 204 and the intermediate node 230. The TCC 202 includes a series connected chain of M Zener diodes 220(1) to 220(M) that are coupled between the reference (ground) pin 204 and the intermediate node 230. The series connection of the Zener diodes 220(1) to 220(M) is in a head-to-tail type connection where the cathode of one Zener diode is directly connected to the anode of the next Zener diode. The anode of the first Zener diode 220(1) in the chain is coupled, preferably directly connected, to the reference (ground) pin 204 at the cathode node K of SCR device 200a. The cathode of the last Zener diode 220(M) is coupled to the intermediate node 230 through a blocking diode 222. The cathode of the blocking diode 222 is coupled, preferably directly connected, to the cathode of the last Zener diode 220(M) and the anode of the blocking diode 222 is coupled, preferably directly connected, to the intermediate node 230 at the anode node A of SCR device 200a. The activation voltage V_{TCC} of the TCC 202 is set to be less than the avalanche breakdown voltage V_{SCR} of the SCR device 200a.

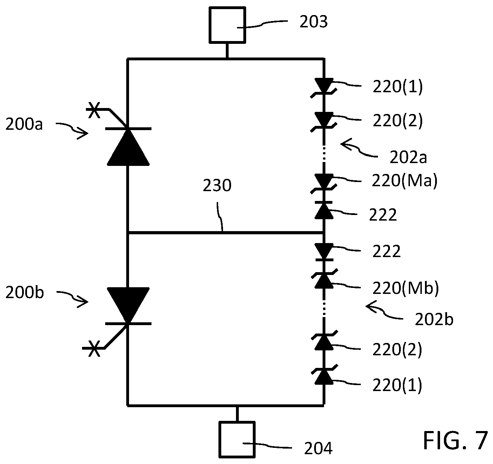

Reference is now made to Figure 7 which shows a circuit diagram for another embodiment of an ESD protection circuit. Here, the included two terminal SCR devices 200 are shown by use of their conventional schematic symbols. The SCR device 200a has a cathode node K terminal coupled, preferably directly connected, to signal pin 203, an anode node A terminal coupled, preferably directly connected, to intermediate node 230, and a disconnected cathode gate (indicated by the "X" for no transistor base access or trigger circuit connection). The SCR device 200b has a cathode node K terminal coupled, preferably directly connected, to reference (ground) pin 204, an anode node A terminal coupled, preferably directly connected, to intermediate node 230, and a disconnected cathode gate (indicated by the "X" for no transistor base access or trigger circuit connection). Importantly, in view of the two terminal configuration, neither of the SCR devices 200a, 200b are gate controlled by a trigger circuit for turn on in any way (i.e., these SCR devices support self-turn on dependent on applied voltage as discussed above).

A first TCC 202a is connected between the signal pin 203 and the intermediate node 230. The first TCC 202a includes a series connected chain of Ma Zener diodes 220(1) to 220(Ma) that are coupled between the signal pin 203 and the intermediate node 230. The series connection of the Zener diodes 220(1) to 220(Ma) is in a head-to-tail type connection where the cathode of one Zener diode is directly connected to the anode of the next Zener diode. The anode of the first Zener diode 220(1) in the chain is coupled, preferably directly connected, to signal pin 203 at the cathode of SCR device 200a. The cathode of the last Zener diode 220(Ma) is coupled to the intermediate node 230 through a blocking diode 222. The cathode of the blocking diode 222 is coupled, preferably directly connected, to the cathode of the last Zener diode 220(Ma) and the anode of the blocking diode 222 is coupled, preferably directly connected, to the intermediate node 230 at the anode node A of SCR device 200a. The activation voltage V_{TCC} of the TCC 202a is set to be less than the avalanche breakdown voltage V_{SCR} of the SCR device 200a.

A second TCC 202b is connected between the reference (ground) pin 204 and the intermediate node 230. The TCC 202b includes a series connected chain of Mb Zener diodes 220(1) to 220(Mb) that are coupled between the reference (ground) pin 204 and the intermediate node 230. The series connection of the Zener diodes 220(1) to 220(Mb) is in a head-to-tail type connection where the cathode of one Zener diode is directly connected to the anode of the next Zener diode. The anode of the first Zener diode 220(1) in the chain is coupled, preferably directly connected, to the reference (ground) pin 204 at the cathode node K of the SCR device 202b. The cathode of the last Zener diode 220(Mb) is coupled to the ground pin 204 through a blocking diode 222. The cathode of the blocking diode 222 is coupled, preferably directly connected, to the cathode of the last Zener diode 220(Mb) and the anode of the blocking diode 222 is coupled, preferably directly connected, to the intermediate node 230 at the anode node A of SCR device 200b. The activation voltage V_{TCC} of the TCC 202b is set to be less than the avalanche breakdown voltage V_{SCR} of the SCR device 200b.

It will be noted that Ma and Mb do not have to be equal to each other. In the case where Ma and Mb are not equal, the activation voltages V_{TCC} of the TCC 202a and TCC 202b will likewise not be equal. In such a case, the avalanche breakdown voltages V_{SCR} of the SCR device 200a and SCR device 200b will likewise not be equal and should be aligned with appropriate margins relative to the activation voltages V_{TCC}. In other embodiments, Ma and Mb are equal, and the activation voltages V_{TCC} of the TCC 202a and TCC 202b will be equal. In this case, the avalanche breakdown voltages V_{SCR} of the SCR device 200a and SCR device 200b will be equal and aligned with appropriate margins relative to the activation voltages V_{TCC}.

While the invention has been illustrated and described in detail in the drawings and foregoing description, such illustration and description are considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims.

In particular, the present invention may be summarized as it follows.

In one aspect of the invention, it is provided an electrostatic discharge (ESD) protection circuit, comprising:
a first semiconductor controlled rectifier (SCR) device of two terminal type consisting of an anode terminal and a cathode terminal, and wherein said first SCR device has an avalanche breakdown voltage for self-turn on;
a first circuit path having a first node and a second node, and wherein said first circuit path has an activation voltage for turn on;
wherein the first SCR device and first circuit path are connected in electrical parallel with the anode terminal and the first node coupled to a first pin and with the cathode terminal and the second node coupled to a second pin; and
wherein said activation voltage is less than the avalanche breakdown voltage.

In a further aspect of the ESD protection circuit, both a cathode gate node and an anode gate node of the first SCR device are not connected to a triggering circuit for controlling turn on of the first SCR device.

In a further aspect of the ESD protection circuit, the first circuit path comprises a series connected chain of M Zener diodes that are coupled between the anode terminal and the cathode terminal of the first SCR device, wherein said activation voltage is dependent on M times a reverse breakdown voltage of the Zener diode.

In a further aspect of the ESD protection circuit, said first circuit path further includes a diode directly connected in series with the series connected chain of M Zener diodes.

In a further aspect of the ESD protection circuit, a cathode of the diode faces the cathode of the Zener diode in said series connected chain of M Zener diodes to which said diode is directly connected.

In a further aspect of the ESD protection circuit, said avalanche breakdown voltage set by a breakdown avalanche of a PN junction of the first SCR device.

In a further aspect of the ESD protection circuit, the first SCR device includes an NPN-type bipolar transistor coupled to a PNP-type bipolar transistor, and wherein said PN junction of the first SCR device is a junction between a collector and base of the NPN-type bipolar transistor.

In a further aspect, the ESD protection circuit further comprising a second SCR device of two terminal type consisting of an anode terminal and a cathode terminal, and wherein the anode terminal of the second SCR device is coupled to the anode terminal of the first SCR device, and wherein the cathode terminal of the second SCR device is coupled to the first pin.

In a further aspect of the ESD protection circuit, the first pin is a signal pin for input/output of an integrated circuit and the second pin is a reference pin for a ground reference of the integrated circuit.

In a further aspect of the ESD protection circuit, the first pin is a reference pin for a ground reference of an integrated circuit signal and the second pin is a signal pin for input/output of the integrated circuit.

In a further aspect of the ESD protection circuit. said second SCR device has an avalanche breakdown voltage for self-turn on.

In a further aspect of the ESD protection circuit, both a cathode gate node and an anode gate node of the second SCR device are not connected to a triggering circuit for controlling turn on of the second SCR device.

In a further aspect, the ESD protection circuit further comprising:
a second circuit path having a first node and a second node, and wherein said second circuit path has an activation voltage for turn on;
wherein the second SCR device and second circuit path are connected in electrical parallel; and
wherein said activation voltage of the second circuit path is less than the avalanche breakdown voltage of the second SCR device.

In a further aspect of the ESD protection circuit:
the first circuit path comprises a series connected chain of Ma Zener diodes that are coupled between the anode terminal and the cathode terminal of the first SCR device, wherein said activation voltage is dependent on Ma times a reverse breakdown voltage of the Zener diode; and
the second circuit path comprises a series connected chain of Mb Zener diodes that are coupled between the anode terminal and the cathode terminal of the second SCR device, wherein said activation voltage is dependent on Mb times a reverse breakdown voltage of the Zener diode.

In a further aspect of the ESD protection circuit, the number Ma of Zener diodes in the first circuit path and the number Mb of Zener diodes in the second circuit path are equal.

In a further aspect of the ESD protection circuit, the number Ma of Zener diodes in the first circuit path and the number Mb of Zener diodes in the second circuit path are not equal.

In a further aspect of the ESD protection circuit, said second circuit path further includes a diode directly connected in series with the series connected chain of Mb Zener diodes.

According to another embodiment of the invention, it is provided an electrostatic discharge (ESD) protection circuit, comprising:
a semiconductor controlled rectifier (SCR) device having an anode terminal directly connected to a first pin of an integrated circuit, a cathode terminal directly connected to a second pin of the integrated circuit, and wherein both a cathode gate node and an anode gate node of the SCR device are not connected to a triggering circuit for controlling turn on of the SCR device; and
a circuit path having a first end node directly connected to the first pin of the integrated circuit and a second end directly connected to the second pin of the integrated circuit, wherein said circuit path comprises a series connected chain of M Zener diodes;
wherein the SCR device has an avalanche breakdown voltage for turn on, said avalanche breakdown voltage set by a breakdown avalanche of a PN junction of the SCR device;
wherein the circuit path has an activation voltage for turn on, said activation voltage being dependent on M times a Zener diode reverse breakdown voltage;
wherein said activation voltage is less than the avalanche breakdown voltage;
and, optionally:said circuit path further includes a diode directly connected in series with the series connected chain of M Zener diodes, wherein a cathode of the diode is directly connected to a cathode of one Zener diode in said series connected chain of M Zener diodes;
and/or, optionally:
   the SCR device includes an NPN-type bipolar transistor coupled to a PNP-type bipolar transistor, and wherein said PN junction of the SCR device is a junction between a collector and base of the NPN-type bipolar transistor;
   and/or, optionally:
      wherein the first pin of the integrated circuit is a signal pin for input/output, and wherein the second pin of the integrated circuit is a reference pin for a ground reference.

## Claims

1. An electrostatic discharge, ESD, protection circuit, comprising:
a semiconductor controlled rectifier, SCR, device (200) having an anode terminal (A) directly connected to a first pin (203) of an integrated circuit, a cathode terminal (K) directly connected to a second pin (204) of the integrated circuit, and wherein both a cathode gate node and an anode gate node of the SCR device are not connected to a triggering circuit for controlling turn on of the SCR device; and
a circuit path (202) having a first end node directly connected to the first pin (203) of the integrated circuit and a second end directly connected to the second pin (204) of the integrated circuit, wherein said circuit path comprises a series connected chain of M Zener diodes (220(1)-220(M));
wherein the SCR device (200) has an avalanche breakdown voltage at which self-turn on of the SCR device (200) takes place, said avalanche breakdown voltage being set by a breakdown avalanche of a PN junction of the SCR device;
wherein the circuit path (202) has an activation voltage for turn on of the circuit path (202), said activation voltage being dependent on M times a Zener diode reverse breakdown voltage; and
wherein said activation voltage is less than said avalanche breakdown voltage.

2. The ESD protection circuit of claims 1, wherein said circuit path (202) further includes a diode (222) directly connected in series with the series connected chain of M Zener diodes (220(1)-220(M)).

3. The ESD protection circuit of claim 2, wherein a cathode of the diode (222) is directly connected to a cathode of one Zener diode (220(M)) in said series connected chain of M Zener diodes (220(1)-220(M)).

4. The ESD protection circuit of anyone of the preceding claims, wherein the SCR device (200) includes an NPN-type bipolar transistor coupled to a PNP-type bipolar transistor, and wherein said PN junction of the SCR device (200) is a junction between a collector and base of the NPN-type bipolar transistor.

5. The ESD protection circuit of anyone of the preceding claims, wherein the first pin (203) of the integrated circuit is a signal pin for input/output, and wherein the second pin (204) of the integrated circuit is a reference pin for a ground reference.

6. The ESD protection circuit of anyone of the preceding claims, wherein the series connected chain of M Zener diodes (220(1)-220(M)) is coupled between the anode terminal (A) and the cathode terminal (K) of the SCR device (200).

7. The ESD protection circuit of anyone of the preceding claims, wherein a cathode of a first Zener diode (220(M)) in said series connected chain of M Zener diodes (220(1)-220(M)) is coupled to the anode terminal (A) of the SCR device (200) and wherein an anode of a second Zener diode (220(1)) in said series connected chain of M Zener diodes (220(1)-220(M)) is directly connected to the cathode terminal (K) of the SCR device (200).

8. The ESD protection circuit of anyone of the preceding claims, wherein each Zener diode of the series connected chain of M Zener diodes (220(1)-220(M)) has a size (N) greater than or equal to 20, where the size (N) is a number of diode structures connected in parallel for each Zener diode.

9. The ESD protection circuit of claim 8, wherein said size (N) is equal to 20.

10. The ESD protection circuit of anyone of claims 8-9, wherein the size (N) is smaller than or equal to 40.

11. The ESD protection circuit of the preceding claim, wherein the size (N) is equal to 40.

12. The ESD protection circuit of claim 8, wherein the size (N) is greater than or equal to 40.
